# EUROPÄISCHE PATENTANMELDUNG

(11) **EP 1 357 473 A1**
(43) Veröffentlichungstag der Anmeldung: **29.10.2003**
(21) Anmeldenummer: 02009072.6
(22) Anmeldetag: 23.04.2002
(51) Int. Cl.: G06F 11/26, G01R 31/319

(54) **Verfahren und Schaltungsanordnung zum Testen elektronischer Bausteine und Baugruppen**

(71) Anmelder: SIEMENS AKTIENGESELLSCHAFT, 80333 München (DE)
(72) Erfinder: Ghameshlu, Majid, 1110 Wien (AT); Krause, Karlheinz, 82152 Planegg (DE)

(57) **Zusammenfassung**

Die logische Verifikation elektronischer Systeme bestehend aus elektronischen Bausteinen, Baugruppen und Software während der Designphase gilt heute aufgrund der hohen Komplexität als unverzichtbares Erfordernis. Häufig werden elektronische Bausteine auf einem zu diesem Zweck erstellten Verifikationssystem emuliert. Die maximal erreichbare Betriebstaktrate (E) des Emulationsboards liegt weit unter der Systemtaktrate des Zielboards. Werden auf dem Zielboard Bausteine (CPU) eingesetzt, die nicht mit einer beliebig niedrigen Frequenz betreibbar sind, beispielsweise weil interne Einheiten (PLL) die Einstellung einer solchen niedrigen Frequenz verhindern, kann ein solches Verifikationssystem nicht ohne Hilfsmittel aufgebaut werden. Das erfindungsgemäße Verfahren und die erfindungsgemäße Schaltungsanordnung sehen vor, die logische Verifikation durch eine mit einer ersten Taktrate (E) betriebene Logikschaltung (B), die den zu verifizierenden Baustein oder Baugruppe emuliert, und einen mit einer zweiten Taktrate (H) betriebenen elektronischer Baustein (CPU) durchzuführen, wobei ein Taktratenkonverter (T) den schnelleren Teil der Testanordnung verzögert und eine Anpassung der Zeitregimes von Schnittstellen (Bus1, Bus2) vornimmt.

## Beschreibung

Die logische Verifikation elektronischer Systeme bestehend aus elektronischen Bausteinen, Baugruppen und Software während der Designphase gilt heute aufgrund der hohen Komplexität als unverzichtbares Erfordernis.

Ein für diese Verifikation häufig verwendetes Verfahren ist die Emulation der zu entwickelnden elektronischen Bausteine auf einem zu diesem Zweck erstellten Verifikationssystem. Dabei handelt es sich in der Regel um ein sogenanntes Emulationsboard, das dem Zielboard möglichst nahe kommt. Auf diesem Emulationsboard werden die Funktionalitäten des zu emulierenden Bausteins entweder von einem marktüblichen computergestützten Emulator oder von einem FPGA (für: Field Programmable Gate Array) übernommen.

In beiden Fällen liegt die maximal erreichbare Betriebstaktrate des Emulationsboards in der Regel weit unter der Systemtaktrate des Zielboards. Die Betriebstaktrate eines Emulationsboards liegt beispielsweise unter 1 MHz. Diese Betriebstaktrate bestimmt die "Systemtaktrate" für das Emulationsboard, wohingegen die Systemtaktrate des Zielboards um Größenordnungen höher ist, beispielsweise größer als 100 MHz. Für eine logische oder funktionale Verifikation resultiert aus der vergleichsweise geringen Betriebstaktrate keine Einschränkung, abgesehen von der entsprechend geringeren Verarbeitungsgeschwindigkeit der Emulationsboards.

Ein Problem tritt jedoch dann auf, wenn die auf dem Zielboard zu verwendenden Bausteine, insbesondere beispielsweise CPU Bausteine (für: Central Processing Unit), nicht mit einer beliebig niedrigen Frequenz betreibbar sind, beispielsweise weil interne PLL Einheiten (für: Phase Locked Loop, Phasenregelschleife) die Einstellung einer solchen niedrigen Frequenz verhindern, da die Betriebstaktrate des Emulationsboards außerhalb des Spezifikationsbereiches der PLL Einheiten liegen.

Bekannte Lösungen des Problems sehen Steuerpins an Bausteinen mit integrierter PLL Einheit vor, über welche die integrierte PLL Einheit deaktiviert werden kann. Nachteilig ist dabei, daß solche Steuerpins einen erhöhten Aufwand beim Entwurf und der Fertigung der Bausteine erfordern, da beispielsweise zusätzliche Steuerpins vorzusehen sind oder gesonderte Signalmuster für vorhandene Steuerpins eingeführt werden müssen, durch welche die integrierte PLL Einheit deaktiviert wird. Zusätzlich muß eine zufällige Deaktivierung der integrierten PLL Einheit im Wirkbetrieb durch geeignete Mechanismen, die wiederum Aufwand erfordern, verhindert werden.

Eine weitere Lösung würde darin bestehen, für die Emulation auf Bausteine zurückzugreifen, die keine oder eine deaktivierbare integrierte PLL Einheit aufweisen. Diese Lösung wäre jedoch unvorteilhaft, da einerseits nicht sichergestellt ist, ob die Funktionalitäten ausreichend abgedeckt sind und andererseits vergleichbare Bausteine in vielen Fällen nicht existieren und mit hohem Aufwand entworfen und hergestellt werden müßten.

Die der vorliegenden Erfindung zugrundeliegende Aufgabe besteht darin, ein Verfahren und eine Schaltungsanordnung zum Testen elektronischer Bausteine und Baugruppen mit nichtdeaktivierbaren integrierten PLL Einheiten anzugeben.

Diese Aufgabe wird durch ein Verfahren zum Testen elektronischer Bausteine und Baugruppen und durch eine Schaltungsanordnung zum Testen elektronischer Bausteine und Baugruppen gemäß der Merkmale der Patentansprüche 1 und 5 gelöst.

Bevorzugte Ausführungsformen sind Gegenstand der abhängigen Ansprüche.

Erfindungsgemäß wird ein Verfahren zum Testen elektronischer Bausteine oder Baugruppen vorgesehen, demgemäß
- der zu testende Baustein oder die zu testende Baugruppe durch eine Logikschaltung B emuliert wird, wobei die Logikschaltung B mit einer ersten Taktrate E betrieben wird,
- ein weiterer elektronischer Baustein CPU, der im Wirkbetrieb mit dem zu testenden Baustein verbunden oder Bestandteil der zu testenden Baugruppe ist, mit einer zweiten Taktrate H betrieben wird,
- ein Taktratenkonverter T über eine gemäß der ersten Taktrate E betriebene erste Schnittstelle Bus1 mit der Logikschaltung B verbunden wird,
- der Taktratenkonverter T über eine gemäß der zweiten Taktrate H getaktete zweite Schnittstelle Bus2 mit dem weiteren Baustein CPU verbunden wird und
- durch den Taktratenkonverter T über die erste Schnittstelle Bus1 übertragene Signale an über die zweite Schnittstelle Bus2 übertragene Signale angepaßt werden, indem durch den Taktratenkonverter T gemäß der in den Taktratenkonverter T eingegebenen Taktraten E, H über die Schnittstellen Bus1, Bus2 empfangene Signale durch Speicherelemente des Taktratenkonverters T zwischengespeichert und zur Ausgabe an die jeweils andere Schnittstelle Bus1, Bus2 vorgesehen werden, und indem durch den Taktratenkonverter T über diejenige Schnittstelle Bus1, Bus2, die gemäß der höheren der Taktraten E, H getaktet ist, Wartezyklen signalisiert werden.

Vorteilhaft ist durch die Verwendung des erfindungsgemäßen Verfahrens und der erfindungsgemäßen Schaltungsanordnung der Einsatz von Ersatzbausteine mit deaktivierbarer PLL Einheit nicht erforderlich. Die durch die Ersatzbausteine bedingten funktionalen Einschränkungen werden somit vermieden.

In den Fällen, in denen keine Ersatzbausteine vorhanden sind und der Entwurf und die Herstellung solcher Ersatzbausteine ökonomisch nicht sinnvoll sind, wird durch die Erfindung das Testen des Zielboards überhaupt erst möglich.

Im folgenden wird das erfindungsgemäße Verfahren und die erfindungsgemäße Schaltungsanordnung im Zusammenhang mit einer Zeichnung als Ausführungsbeispiel näher erläutert.

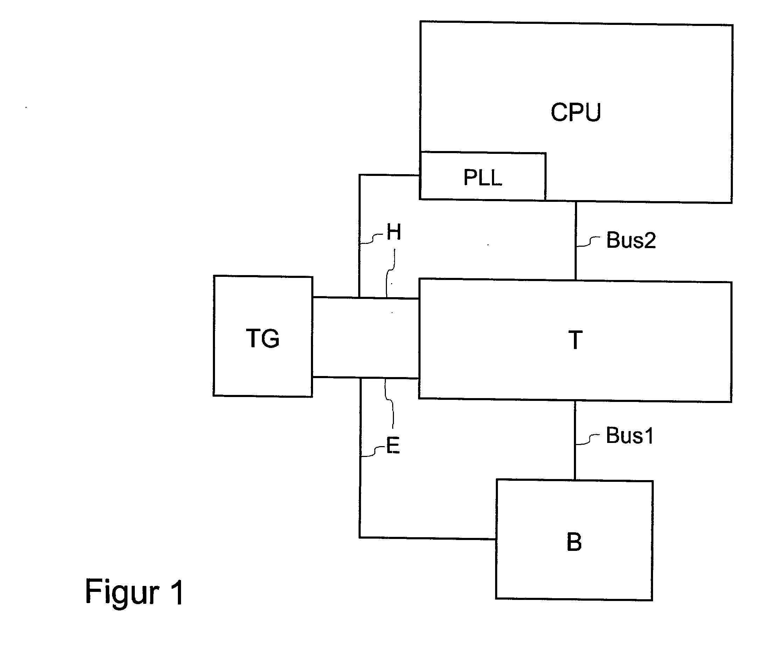

Die Figur zeigt einen beispielhaften Testaufbau für die logische Verifikation einer elektronischen Baugruppe. Diese Baugruppe weist einen Baustein CPU auf, wobei dieser Baustein CPU eine integrierte Phasenregelschleife PLL aufweist. Da im Wirkbetrieb eine deaktivierbare Phasenregelschleife PLL keine Vorteile, jedoch durchaus Nachteile beispielsweise in Form zusätzlich benötigter Signalpins oder Testsignalmuster mit sich bringt, ist diese Phasenregelschleife PLL in vielen Fällen nicht deaktivierbar ausgeführt. Dies hat zur Folge, daß der Baustein CPU nur mit seiner Betriebstaktrate H betrieben werden kann.

Die Funktionalität des zu verifizierenden Bausteins oder der zu verifizierenden Baugruppe wird mittels einer Logikschaltung B emuliert. Die maximal durch Emulation erreichbare Betriebstaktrate E dieser Logikschaltung B liegt jedoch weit unter der Systemtaktrate der gesamten Baugruppe im Wirkbetrieb, beispielsweise unter 1 MHz. Diese Betriebstaktrate E der Logikschaltung bestimmt für den Verifikationstest die "Systemtaktrate" für gesamte Schaltung während der Emulation, also auch für den Baustein CPU.

Zur Anpassung der verschiedenen Betriebstaktraten E, H ist erfindungsgemäß ein Taktratenkonverter T, der auch als Bus Speed Converter bezeichnet wird, vorgesehen. Der Taktratenkonverter T ist über eine erste Schnittstelle Bus1 mit der Logikschaltung B und über eine zweite Schnittstelle Bus2 mit dem Baustein CPU verbunden. Diese Schnittstellen Bus1, Bus2 sind logisch gleichwertig und unterscheiden sich lediglich hinsichtlich der jeweiligen Taktrate. Dabei orientiert sich die Taktrate der ersten Schnittstelle Bus1 an der Taktrate E der Logikschaltung B und die Taktrate der zweiten Schnittstelle Bus2 orientiert sich an der Taktrate H des Bausteins CPU. Beispielsweise kann die Taktrate der ersten Schnittstelle der Taktrate E der Logikschaltung B entsprechen, und/oder die Taktrate der zweiten Schnittstelle kann der Taktrate H des Bausteins CPU entsprechen. Darüberhinaus gilt, daß die zweite Schnittstelle Bus2 der Schnittstelle im Wirkbetrieb zwischen dem Baustein CPU und der restlichen Baugruppe entspricht.

Der Taktratenkonverter T verfügt über Speicherelemente, die beispielsweise als FIFO (First-In/First-Out) Speicherelemente ausgeführt sind - nicht dargestellt. Außerdem werden beide Taktraten E, H an den Taktratenkonverter geliefert. Für die Erzeugung der Taktraten E, H ist ein Taktgenerator TG vorgesehen, dabei ist die Art der Erzeugung der beiden unterschiedlichen Taktraten E, H für diese Erfindung unwesentlich.

Die logische Verifikation gestaltet sich wie folgt: Die zu emulierende Logikschaltung B wird mit einer geeigneten ersten Betriebstaktrate E vom Taktgenerator TG versorgt, und der Baustein CPU wird mit einer zweiten Betriebstaktrate H versorgt. Eine Datenübermittlung vom Baustein CPU zur Logikschaltung B oder umgekehrt erfolgt durch den Taktratenkonverter T, der über zwei entsprechend verschieden getaktete Schnittstellen Bus1, Bus2 zum Baustein CPU und zur Logikschaltung B verfügt.

Ohne Beschränkung der Allgemeinheit wird im folgenden davon ausgegangen, daß die erste Taktrate E wesentlich kleiner sei als die Taktrate H. Außerdem sei, wie bereits erwähnt, angenommen, daß die erste Schnittstelle Bus1 mit der Taktrate E getaktet wird und die zweite Schnittstelle Bus2 mit der Taktrate H. Es ist natürlich ebenfalls möglich, daß die Schnittstellen Bus1, Bus2 jeweils mit einem Vielfachen oder einem Bruchteil der jeweiligen Bezugstaktrate E, H betrieben werden. Wichtig ist lediglich, daß die Taktrate der ersten Schnittstelle Bus1 auf die erste Taktrate E abgestimmt ist und daß die Taktrate der zweiten Schnittstelle Bus2 auf die zweite Taktrate H abgestimmt ist.

Bei einer Datenübertragung vom Baustein CPU an die zu emulierende Logikschaltung B werden zunächst diese Daten über die zweite Schnittstelle Bus2 an den Taktratenkonverter T übertragen, dabei erfolgt die Datenübertragung mit dem für die zweite Schnittstelle Bus2 geltenden Zeitregime. Dabei sind die übertragenen Daten beispielsweise nur für eine Taktperiode der zweiten Schnittstelle Bus2 gültig. Da diese Taktperiode der zweiten Schnittstelle Bus2 aufgrund der wesentlich höheren zweiten Taktrate H wesentlich kürzer ist als eine Taktperiode der ersten Schnittstelle Bus1, werden die Daten in den Pufferspeicherelementen des Taktratengenerators T, zwischengespeichert und entsprechend des für die erste Schnittstelle Bus1 geltenden Zeitregimes an die Logikschaltung B ausgegeben.

Bei einer Datenübertragung der zu emulierenden Logikschaltung B an den vom Baustein CPU werden zunächst diese Daten über die zweite Schnittstelle Bus1 an den Taktratenkonverter T übertragen, dabei erfolgt die Datenübertragung mit dem für die erste Schnittstelle Bus1 geltenden Zeitregime. Die Daten werden in den Pufferspeicherelementen des Taktratengenerators T zwischengespeichert und entsprechend des für die zweite Schnittstelle Bus1 geltenden Zeitregimes an den Baustein CPU ausgegeben. Da eine Taktperioden der zweiten Schnittstelle Bus2 wesentlich kürzer ist als eine Taktperiode der ersten Schnittstelle Bus1, d.h. zwischen zwei Takten der ersten Schnittstelle Bus2 liegen viele Takte der zweiten Schnittstelle Bus2 vor, muß sichergestellt sein, daß die Daten auf der zweiten Schnittstelle Bus2 durch den Baustein CPU nicht angefordert werden, bevor diese durch die Logikschaltung B über die erste Schnittstelle Bus1 bereitgestellt werden.

In beiden Fällen wird, um die Verarbeitungsgeschwindigkeit des Bausteins CPU, die in direktem Zusammenhang mit der zweiten Taktrate H steht, an die langsamere erste Taktrate E anzupassen, durch den Taktratenkonverter T mittels geeigneter Befehle oder Signale Wartezyklen an den Baustein CPU signalisiert, beispielsweise in Form von WAIT Signalen oder NOP Befehlen (für: No Operation). Anders ausgedrückt wird durch den Taktratenkonverter T sichergestellt, daß der mit der höheren zweiten Taktrate H betriebene Baustein B mit dem Zeitregime der geringeren ersten Taktrate E harmoniert.

Die vorliegende Erfindung ist nicht auf das Ausführungsbeispiel beschränkt. Beispielsweise kann eine Anwendung des erfindungsgemäßen Verfahrens auch in anderen Situationen erfolgen, in denen eine Taktratenanpassung notwendig ist.

Eine solche Situation wäre die Verwendung einer schnellaufenden Komponente, beispielsweise einer CPU, in einer ansonsten langsam laufenden Schaltung, motiviert beispielsweise dadurch, daß vergleichsweise hoch getaktete CPU Bausteine kostengünstig und in hohen Stückzahlen erhältlich sind, langsame CPU Bausteine hingegen zunehmend in geringeren Stückzahlen und daher teurer gefertigt werden.

## Patentansprüche

1. Verfahren zum Testen elektronischer Bausteine oder Baugruppen, demgemäß
- der zu testende Baustein oder die zu testende Baugruppe durch eine Logikschaltung (B) emuliert wird, wobei die Logikschaltung (B) mit einer ersten Taktrate (E) betrieben wird,
- ein weiterer elektronischer Baustein (CPU), der im Wirkbetrieb mit dem zu testenden Baustein verbunden oder Bestandteil der zu testenden Baugruppe ist, mit einer zweiten Taktrate (H) betrieben wird,
- ein Taktratenkonverter (T) über eine gemäß der ersten Taktrate (E) betriebene erste Schnittstelle (Bus1) mit der Logikschaltung (B) verbunden wird,
- der Taktratenkonverter (T) über eine gemäß der zweiten Taktrate (H) getaktete zweite Schnittstelle (Bus2) mit dem weiteren Baustein (CPU) verbunden wird und
- durch den Taktratenkonverter (T) über die erste Schnittstelle (Bus1) übertragene Signale an über die zweite Schnittstelle (Bus2) übertragene Signale angepaßt werden, indem durch den Taktratenkonverter (T) gemäß der in den Taktratenkonverter (T) eingegebenen Taktraten (E, H) über die Schnittstellen (Bus1, Bus2) empfangene Signale durch Speicherelemente des Taktratenkonverters (T) zwischengespeichert und zur Ausgabe an die jeweils andere Schnittstelle (Bus1, Bus2) vorgesehen werden, und indem durch den Taktratenkonverter (T) über diejenige Schnittstelle (Bus1, Bus2), die gemäß der höheren der Taktraten (E, H) getaktet ist, Wartezyklen signalisiert werden.

2. Verfahren nach Anspruch 1,
**dadurch gekennzeichnet,**
**daß** die zweite Taktrate (H) als gleich einer Betriebstaktrate einer internen Phasenregelschleife (PLL) des weiteren elektronischen Bausteins (CPU) gewählt wird, wobei die zweite Taktrate (H) wesentlich höher ist als die erste Taktrate (E).

3. Verfahren nach einem der Ansprüche 1 oder 2,
**dadurch gekennzeichnet,**
**daß** die Wartezyklen durch den Taktratenkonverter (T) an den Baustein (CPU) mittels WAIT Signalen über gesonderte Signalleitungen des Bausteins (CPU) oder mittels NOP Befehlen signalisiert werden.

4. Verfahren nach einem der Ansprüche 1 bis 3,
**dadurch gekennzeichnet,**
**daß** die Logikschaltung (B) zumindest teilweise durch eine computergestützte Simulation oder eine programmierbare Logik realisiert wird.

5. Schaltungsanordnung zum Testen elektronischer Bausteine oder Baugruppen, mit
- einer Logikschaltung (B) zum Emulieren des zu testenden Bausteins oder der zu testenden Baugruppe, wobei die Logikschaltung (B) mit einer ersten Taktrate (E) betrieben wird,
- einem weiteren elektronischen Baustein (CPU), der im Wirkbetrieb mit dem zu testenden Baustein verbunden oder Bestandteil der zu testenden Baugruppe ist, wobei der weitere elektronische Baustein (CPU) mit einer zweiten Taktrate (H) betrieben wird,
- einem Taktratenkonverter (T), der über eine gemäß der ersten Taktrate (E) betriebene erste Schnittstelle (Bus1) mit der Logikschaltung (B) verbunden ist und über eine gemäß der zweiten Taktrate (H) getaktete zweite Schnittstelle (Bus2) mit dem weiteren Baustein (CPU) verbunden ist,
- wobei der Taktratenkonverter (T) über die erste Schnittstelle (Bus1) übertragene Signale an über die zweite Schnittstelle (Bus2) übertragene Signale angepaßt, indem Speicherelemente des Taktratenkonverters (T) gemäß der in den Taktratenkonverter (T) eingegebenen Taktraten (E, H) über die Schnittstellen (Bus1, Bus2) empfangene Signale zwischenspeichern und zur Ausgabe an die jeweils andere Schnittstelle (Bus1, Bus2) vorsehen, und indem der Taktratenkonverter (T) über diejenige Schnittstelle (Bus1, Bus2), die gemäß der höheren der Taktraten (E, H) getaktet ist, Wartezyklen signalisiert.

6. Schaltungsanordnung nach Anspruch 5,
**dadurch gekennzeichnet,**
**daß** der weitere Baustein (CPU) eine interne Phasenregelschleife (PLL) aufweist, durch welche die zweite Taktrate (H) bestimmt ist, wobei die zweite Taktrate (H) wesentlich höher ist als die erste Taktrate (E).

7. Schaltungsanordnung nach einem der Ansprüche 5 oder 6,
**dadurch gekennzeichnet,**
**daß** der Taktratenkonverter First-In/First-Out Speicherelemente aufweist und als Field Programmable Gate Array ausgeführt ist.

8. Schaltungsanordnung nach einem der Ansprüche 5 bis 7,
**dadurch gekennzeichnet,**
**daß** der Taktratenkonverter (T) die Wartezyklen an den Baustein (CPU) mittels WAIT Signalen über gesonderte Signalleitungen des Bausteins (CPU) oder mittels NOP Befehlen signalisiert.

9. Schaltungsanordnung nach einem der Ansprüche 5 bis 8,
**dadurch gekennzeichnet,**
**daß** die Logikschaltung (B) zumindest teilweise eine computergestützte Simulation ist.
